# EUROPÄISCHE PATENTSCHRIFT

(11) **EP 0 760 166 B1**
(45) Veröffentlichungstag und Bekanntmachung des Hinweises auf die Patenterteilung: **15.04.1998**
(21) Anmeldenummer: 95919372.3
(22) Anmeldetag: 02.05.1995
(51) Int. Cl.: H01L 27/108, H01L 21/8242

(54) **GAIN CELL DRAM STRUKTUR UND VERFAHREN ZUR HERSTELLUNG**
GAIN CELL DRAM STRUCTURE AND PROCESS FOR PRODUCING THE SAME
STRUCTURE DE MEMOIRE RAM DYNAMIQUE A CELLULES DE GAIN ET SON PROCEDE DE FABRICATION

(30) Priorität: 17.05.1994 DE 4417150
(43) Veröffentlichungstag der Anmeldung: 05.03.1997
(73) Patentinhaber: SIEMENS AKTIENGESELLSCHAFT, 80333 München (DE)
(72) Erfinder: KRAUTSCHNEIDER, Wolfgang, D-83104 Hohenthann (DE); RISCH, Lothar, D-85579 Neubiberg (DE); HOFMANN, Franz, D-80995 München (DE)
(86) Internationale Anmeldenummer: EP9501656
(87) Internationale Veröffentlichungsnummer: WO9531828

(56) Entgegenhaltungen:
- WO-A-92/01287
- US-A- 4 989 055
- US-A- 4 999 811
- MICROELECTRONIC ENGINEERING, Bd.15, Nr.1-4, Oktober 1991, Amsterdam NL, Seiten 367-370; W.H. KRAUTSCHNEIDER et al.: 'Fully Scalable Gain Memory Cell for Future DRAMs'
- PATENT ABSTRACTS OF JAPAN vol. 14, no. 205 (E-921) (4148) 26. April 1990 & JP-A-02 044 763
- PATENT ABSTRACTS OF JAPAN vol. 14, no. 105 (E-895) (4048) 26. Februar 1990 & JP-A-01 307 256
- IBM TECHNICAL DISCLOSURE BULLETIN, Bd. 34, Nr. 6, November 1991, New York US, Seiten 231-233 'Common-Wordline Compact Merged DRAM Cell'

## Beschreibung

Mit zunehmender Speicherdichte pro Chip von einer Speichergeneration zur nächsten ist die Fläche dynamischer Halbleiterspeicherzellen ständig verkleinert worden. Dazu sind ab der 4Mbit-Speichergeneration dreidimensionale Strukturen erforderlich. Ab der 64 Mbit-Speichergeneration hat die Speicherkapazität einen Wert erreicht, der sich kaum noch reduzieren läßt, so daß eine ungefähr konstante Kapazität auf einer verkleinerten Zellfläche realisiert werden muß. Dies führt zu einem erheblichen technologischen Aufwand. Deshalb ist an eine verbesserte dynamische Halbleiterspeicherzelle die Anforderung zu stellen, daß die Höhe der Signalladung nicht von der Große der Speicherkapazität bestimmt wird.

Diese Anforderung erfüllen Speicherzellen, bei denen die Signalladung nicht von einem Speicherkondensator, sondern von einer Versorgungsspannungsquelle geliefert wird. Dabei ist es ausreichend, im Speicherkondensator nur eine kleinere Ladung zu speichern, die beim Auslesen der Speicherzelle ein Schaltelement so aktiviert, daß eine leitende Verbindung zwischen der Versorgungsspannungsquelle und der Bitleitung hergestellt wird. Derartige Speicherzellen werden als selbstverstärkende Speicherzellen oder Gain Memory Cells bezeichnet.

Aus T. Tsuchiya et al, IEEE Electr. Dev. Lett. (1982), EDL-3, Seite 7 und T. Tsuchiya et al, IEEE Trans. Electr. Dev. (1982), ED-29, Seite 1713 ist eine selbstverstärkende Speicherzelle mit Sperrschicht-Feldeffekttransistor bekannt. Die eingespeicherte Ladung steuert bei diesem Speicherzellentyp die Ausdehnung einer Raumladungszone eines pn-Überganges. Ist die Zelle aufgeladen, so wird die Raumladungszone so vergrößert, daß sie den Stromkanal zwischen Spannungsquelle und Bitleitung abschnürt. Ist dagegen keine Ladung in der Zelle gespeichert, so wird der Stromkanal nicht abgeschnürt und es kann Strom von der Spannungsquelle zur Bitleitung fließen. Bei diesem Zellentyp darf der den pn-Übergang und den Stromkanal bildende Halbleiterbereich nur geringe Toleranzen aufweisen, um sowohl ausreichenden Stromfluß als auch sicheres Sperren bei entsprechender Aufladung sicherzustellen. Darüber hinaus wird zum Schreiben der Information eine zusätzliche Leitung benötigt.

Aus K. Terada et al, IEEE Trans. Electr. Dev. (1982), ED-29, Seite 1301 ist eine selbstverstärkende Speicherzelle mit einem DMOS-Transistor bekannt. Dabei werden ein planarer MOS-Transistor und ein DMOS-Transistor miteinander integriert. Im Substrat des DMOS-Transistors wird die die Information darstellende Ladung gespeichert. Abhängig vom Ladungszustand des Substrates nimmt der DMOS-Transistor zwei verschiedene Schwellenspannungen an. Bei diesem Zelltyp sind auf der Wortleitung positive und negative Spannungen erforderlich. Ferner müssen die Pegel sehr genau eingestellt werden, um beim Auslesen zwischen einer logischen "Null" und "Eins" unterscheiden zu können.

Aus T. N. Blalock et al., Symp. VLSI Circuits Dig. Tech. Pap. (1990) Seite 13, ist eine Zweitransistorspeicherzelle bekannt, die aus der Dreitransistorzelle entwickelt worden ist und bei der der dritte Transistor, der zum Auslesen dient, entfällt. Stattdessen wird der Zustand des Speichertransistors durch matrixförmig angeordnete Leitungen abgefragt. Dieser Zellentyp benötigt vier Leitungen, die im Sinne einer Doppelmatrix über das Zellenfeld gelegt werden müssen. Pro Zelle sind vier Kontakte erforderlich, was die Reduzierung der Zellfläche begrenzt. Ferner lassen sich die Source- und Drain-Bereiche der beiden Transistoren nicht durch ein gemeinsames dotiertes Gebiet realisieren, wie es für eine kleine Zellfläche erforderlich wäre.

Eine selbstverstärkende Speicherzelle mit einem MOS- und einem bipolaren Transistor ist zum Beispiel durch K. Sunouchi et al, IEDM Tech. Dig. (1991), Seite 465, bekannt. In dieser Speicherzelle wird die Verstärkungswirkung eines parasitären bipolaren Transistors ausgenutzt. Dadurch läßt sich die erforderliche Kapazität des Speicherkondensators erheblich verkleinern. Da der bipolare Transistor ein parasitäres Element darstellt, läßt es sich nicht mit der für Speicherzellen erforderlichen Reproduzierbarkeit realisieren. Die Integration eines bipolaren Transistors mit minimalen Designregeln in der Speicherzelle würde zu einer vergleichsweise großen Zellfläche führen.

Aus WO 92/01287 und W. H. Krautschneider et al, Proc. ESSDERC (1991), Seite 367, ist eine selbstverstärkende dynamische MOS-Transistor-Speicherzelle bekannt, die einen Auswahltransistor und einen Speichertransistor umfaßt. In dieser Speicherzelle wird die Ladung in der Gate- und Source-Kapazität des Speichertransistors gespeichert. Die beiden Transistoren sind in Reihe geschaltet und weisen ein gemeinsames Drain-Source-Gebiet auf. Dieses gemeinsame Drain-Source-Gebiet ist über eine Diodenstruktur mit der Gateelektrode des Speichertransistors verbunden. Beim Auslesen wird der Speichertransistor je nach eingespeicherter Information eingeschaltet und schließt dadurch einen Strompfad von der Versorgungsspannung zur Bitleitung. In diesem Zelltyp sind Auswahl- und Speichertransistor in Reihe geschaltet, so daß zum Auslesen des Signals keine spezielle Leitung erforderlich ist.

Aus IBM Technical Disclosure Bulletin, Band 34, Nr. 6, Nov. 1991; S. 231-3 ist eine DRAM-Struktur bekannt, in der zwei Speicherzellen eine Gateelektrode teilen.

Aus US-A-4 999 811 ist eine Zweitransistorspeicherzelle bekannt.

Der Erfindung liegt das Problem zugrunde, ein Verfahren zur Herstellung einer Anordnung mit selbstverstärkenden dynamischen MOS-Transistorspeicherzellen anzugeben, mit dem die Fläche der Speicherzellen weiter reduziert werden kann.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird ein Siliziumsubstrat mit einer vertikalen Folge dotierter Gebiete versehen, die mindestens ein erstes dotiertes Gebiet, ein zweites dotiertes Gebiet und ein drittes dotiertes Gebiet für Source-, Kanal- und Drain-Gebiet von vertikalen MOS-Transistoren umfaßt. In dieser vertikalen Folge dotierter Gebiete werden ein Auswahltransistor und ein Speichertransistor dadurch realisiert, daß Gräben geätzt werden, die jeweils bis in das erste Gebiet hineinreichen und daß die Oberfläche der Gräben mit jeweils einem Gatedielektrikum und einer Gateelektrode versehen wird.

Zwischen den beiden Gräben wird ein weiterer Graben erzeugt, der das erste dotierte Gebiet, das zweite dotierte Gebiet und das dritte dotierte Gebiet durchtrennt. In diesem Graben wird eine Isolationsstruktur gebildet, die das erste dotierte Gebiet und das zweite dotierte Gebiet jeweils in zwei voneinander isolierte Teile trennt. Die durch den weiteren Graben getrennten Teile des dritten dotierten Gebietes werden durch eine Verbindungsstruktur elektrisch miteinander verbunden.

Es wird eine Diodenstruktur erzeugt, deren einer Anschluß mit dem dritten dotierten Gebiet und deren anderer Anschluß mit einer der Gateelektroden elektrisch leitend verbunden ist.

Der Speichertransistor wird in dieser Anordnung durch das erste dotierte Gebiet, das zweite dotierte Gebiet, das dritte dotierte Gebiet und die mit der Diodenstruktur verbundenen Gateelektrode gebildet. Der Auswahltransistor wird durch die andere Gateelektrode, das erste dotierte Gebiet, das zweite dotierte Gebiet und das dritte dotierte Gebiet gebildet. Das dritte dotierte Gebiet mit der Verbindungsstruktur bildet das gemeinsame Source-Drain-Gebiet von Auswahltransistor und Speichertransistor. Die Diodenstruktur wird so dimensioniert, daß ein relativ hoher Stromfluß beim Aufladen und ein relativ niedriger Stromfluß beim Entladen der an der Gateelektrode des Speichertransistors wirksamen Kapazität auftritt.

Der zum Auswahltransistor gehörige Teil des ersten dotierten Gebietes bildet bei einer matrixförmigen Anordnung einer Vielzahl von Speicherzellen eine Bitleitung, der zu dem Speichertransistor gehörigen Teil des ersten dotierten Gebietes eine Versorgungsspannungsleitung. Sowohl die Bitleitung als auch die Versorgungsspannungsleitung sind in der Struktur vergraben und benötigen keine zusätzliche Fläche.

Bei der matrixförmigen Anordnung der Speicherzellen werden Wortleitungen, die die Bitleitungen und die Versorgungsspannungsleitungen kreuzen, an der Oberfläche der Struktur erzeugt. Entlang einer Wortleitung benachbarte Speicherzellen werden vorzugsweise spiegelsymmetrisch aufgebaut, wobei je zwei unmittelbar benachbarte Speicherzellen einen gemeinsamen Wortleitungskontakt aufweisen.

Vorzugsweise wird ein Siliziumsubstrat verwendet, das von einem ersten Leitfähigkeitstyp dotiert ist. Darauf wird zur Bildung des ersten dotierten Gebietes eine von einem zweiten, zum ersten entgegengesetzten Leitfahigkeitstyp dotierte Siliziumschicht epitaktisch aufgewachsen. Zur Bildung des zweiten dotierten Gebietes wird eine vom ersten Leitfähigkeitstyp dotierte Siliziumschicht durch LPCVD-Epitaxie oder durch Molekularstrahlepitaxie aufgebracht. Zur Bildung des dritten dotierten Gebietes wird eine vom zweiten Leitfähigkeitstyp dotierte Siliziumschicht durch LPCVD-Epitaxie oder durch Molekularstrahlepitaxie aufgebracht. LPCVD-Epitaxie ist eine Abkürzung für Low Pressure Chemical Vapour Deposition.

Es liegt im Rahmen der Erfindung, die Diodenstruktur als Schottky-Diode so zu realisieren, daß ein niedriger Widerstandswert beim Aufladen und ein hoher Widerstandswert beim Entladen der an der Gateelektrode wirksamen Kapazität auftritt. Dazu wird die Gateelektrode zum Beispiel aus dotiertem Polysilizium gebildet und eine Schicht aus einem Metall, zum Beispiel Aluminium, darauf abgeschieden.

Alternativ wird die Diodenstruktur als n⁺p-Diode realisiert. Dazu wird vorzugsweise die zweite Gateelektrode aus dotiertem Polysilizium gebildet und mit einer entsprechend dotierten Polysiliziumstruktur versehen. Die dotierte Polysiliziumstruktur und die Gateelektrode stellen gemeinsam die Diodenstruktur dar. Diese Ausführungsform wird im Hinblick auf eine Integration in bestehende VLSI-Technologien bevorzugt. Zur Vereinfachung der späteren Kontaktierung zwischen der dotierten Polysiliziumstruktur und dem dritten dotierten Gebiet liegt es im Rahmen der Erfindung, die Oberfläche der dotierten Polysiliziumstruktur mit einer Metallsilizidschicht zu versehen. Die Metallsilizidschicht wird vorzugsweise in einem selbstjustierenden Prozeß hergestellt.

Die Dotierstoffkonzentration im ersten dotierten Gebiet und im dritten dotierten Gebiet, die jeweils Source/Drain-Gebiete der MOS-Transistoren bilden, werden hochdotiert mit einer Dotierstoffkonzentration von mehr als 10¹⁹ cm⁻³, die Dotierstoffkonzentration im zweiten dotierten Gebiet, das ein Kanalgebiet bildet, wird auf kleiner oder gleich 10¹⁸ cm⁻³ eingestellt. Zur Bildung des ersten und zweiten Gatedielektrikums wird eine thermische Oxidation bei 700 bis 800°C durchgeführt. Dabei bildet sich das Gatedielektrikum auf den hoher dotierten Gebieten mit mehrfacher Dicke im Vergleich zu dem schwächer dotierten Gebiet, das als Kanalbereich eingesetzt wird. Die größere Dicke des Gatedielektrikums an der Oberfläche der Source/Drain-Gebiete bewirkt eine Reduktion der Überlappkapazitäten.

Im folgenden wird die Erfindung anhand eines Ausführungsbeispiels und der Figuren näher erläutert.
- Figur 1: zeigt ein Siliziumsubstrat mit einer vertikalen Folge dotierter Gebiete.
- Figur 2: zeigt das Siliziumsubstrat nach der Bildung von Gräben, die jeweils mit Gatedielektrikum und Gateelektrode für einen Auswahltransistor und einen Speichertransistor versehen sind.
- Figur 3: zeigt das Siliziumsubstrat nach der Bildung einer Diodenstruktur.
- Figur 4: zeigt das Siliziumsubstrat nach der Bildung von isolierenden Gräben zwischen dem Auswahltransistor und dem Speichertransistor sowie zu benachbarten Speicherzellen hin.
- Figur 5: zeigt das Siliziumsubstrat nach Bildung einer Verbindungsstruktur zwischen dem dritten dotierten Gebiet und einer Diodenstruktur.
- Figur 6: zeigt das Siliziumsubstrat nach der Bildung von Wortleitungskontakten.
- Figur 7: zeigt eine Aufsicht auf eine erfindungsgemäß hergestellte Speicherzellenanordnung.
- Figur 8: zeigt ein Ersatzschaltbild einer nach dem erfindungsgemäßen Verfahren hergestellten Speicherzelle.

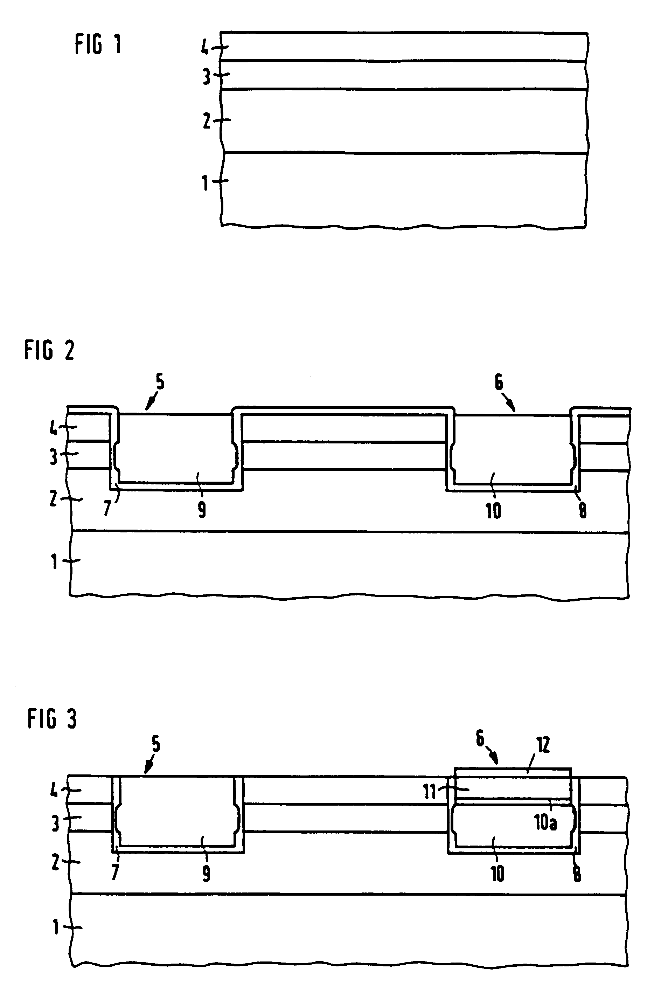

Auf ein Siliziumsubstrat 1, das zum Beispiel p-dotiert ist mit einer Dotierstoffkonzentration von 10¹⁶ cm⁻³, wird epitaktisch eine n⁺-dotierte Schicht 2 mit einer Dotierstoffkonzentration von zum Beispiel 3 x 10¹⁹ cm-3 aufgewachsen (siehe Figur 1). Die erste dotierte Siliziumschicht 2 wird in einer Dicke von zum Beispiel 300 nm aufgebracht.

Auf die erste dotierte Siliziumschicht 2 wird eine zweite dotierte Siliziumschicht 3, die zum Beispiel p-dotiert ist mit einer Dotierstoffkonzentration von 8 x 10¹⁷cm^{-3,} und darauf eine dritte dotierte Siliziumschicht 4, die zum Beispiel n⁺-dotiert ist mit einer Dotierstoffkonzentration von 3 x 10¹⁹cm⁻³ , aufgebracht. Die zweite dotierte Siliziumschicht 3 und die dritte dotierte Siliziumschicht 4 werden in einer Dicke von jeweils etwa 150 nm mit Hilfe von epitaktischen Verfahren wie LPCVD-Epitaxie oder Molekularstrahlepitaxie erzeugt. Die LPCVD-Epitaxie (das ist eine Abkürzung für Low Pressure Chemical Vapour Deposition) erfolgt zum Beispiel mit Silan und Diboran oder Arsin im Temperaturbereich von 700 bis 900°C und im Druckbereich von 2 bis 20 mbar (1 mbar = 100 Nm⁻²). Die Molekularstrahlepitaxie erfolgt vorzugsweise im Temperaturbereich von 520°C und im Druckbereich von 5 x 10⁻¹⁰ mbar.

Unter Verwendung einer Maske (nicht dargestellt) werden durch anisotropes Ätzen ein erster Graben 5 und ein zweiter Graben 6 erzeugt, die jeweils bis in die erste dotierte Schicht 2 hineinreichen (siehe Figur 2). Durch thermische Oxidation bei 700 bis 800°C werden an den Wänden und dem Boden des ersten Grabens 5 ein erstes Gatedielektrikum 7 aus SiO₂ und an den Wänden und dem Boden des zweiten Grabens 6 ein zweites Gatedielektrikum 8 aus SiO₂ erzeugt. Bedingt durch die Dotierstoffkonzentration in der ersten dotierten Schicht 2, der zweiten dotierten Schicht 3 und der dritten dotierten Schicht 4 wächst das erste Gatedielektrikum 7 und das zweite Gatedielektrikum 8 an der Oberfläche der zweiten dotierten Schicht 3 jeweils in einer um etwa ein Drittel geringeren Dicke als an der Oberfläche der ersten dotierten Schicht 2 sowie der dritten dotierten Schicht 4 auf. Durch Auffüllen mit in situ n⁺-dotiertem Polysilizium werden im ersten Graben 5 eine erste Gateelektrode 9 und im zweiten Graben 6 eine zweite Gateelektrode 10 erzeugt.

Die zweite Gateelektrode 10 wird rückgeätzt, so daß sie in der Höhe in etwa mit der Höhe der zweiten dotierten Schicht 3 abschließt (siehe Figur 3). Die übrige Oberfläche wird dabei mit einer Maske vor dem Ätzangriff geschützt (nicht dargestellt). Auf die zweite Gateelektrode 10 wird eine Diffusionsbarriereschicht 10a aufgebracht. Die Diffusionsbarriereschicht 10a wird aus einer sehr dünnen Oxidschicht mit einer Dicke von zum Beispiel 1 nm oder einer sehr dünnen Silizidschicht mit einer Dicke von zum Beispiel 2 nm gebildet. In dem zweiten Graben 6 wird anschließend durch Auffüllen mit in situ dotiertem p-Polysilizium eine dotierte Polysiliziumstruktur 11 erzeugt, die den zweiten Graben im wesentlichen auffüllt. Die Diffusionsbarriereschicht 10a auf der Oberfläche der zweiten Gateelektrode 10 verhindert eine Ausdiffusion der Dotierstoffe der dotierten Polysiliziumstruktur 11 in die zweite Gateelektrode 10.

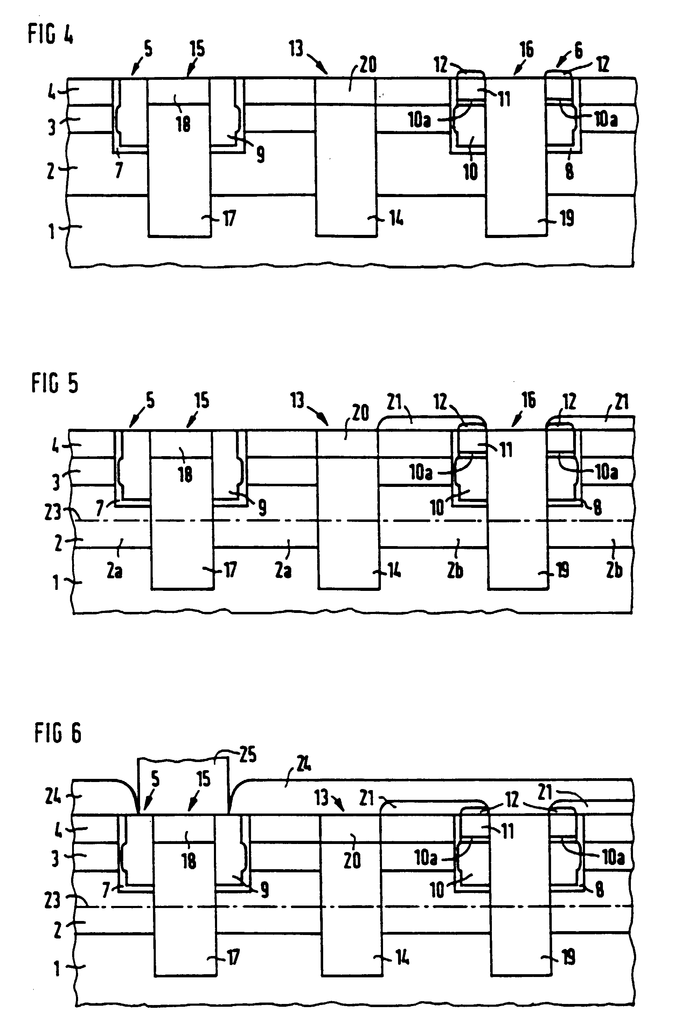

Zur Vereinfachung der späteren Kontaktierung wird die dotierte Polysiliziumstruktur 11 mit einer selbstjustierenden Metallsilizidschicht 12 versehen. Zwischen dem ersten Graben 5 und dem zweiten Graben 6 wird ein dritter Graben 13 erzeugt, der bis in das Substrat 1 hineinreicht. Der dritte Graben 13 durchtrennt die erste dotierte Schicht 2, die zweite dotierte Schicht 3 sowie die dritte dotierte Schicht 4. Der dritte Graben 13 wird mit einer ersten Isolationsstruktur 14 aus zum Beispiel SiO₂ versehen, die mindestens bis zur Höhe der zweiten dotierten Schicht 3 reicht (siehe Figur 4).

Gleichzeitig wird innerhalb des ersten Grabens 5 ein vierter Graben 15 und innerhalb des zweiten Grabens 6 ein fünfter Graben 16 erzeugt. Der vierte Graben 15 und der fünfte Graben 16 reichen jeweils bis in das Substrat 1 hinein und durchtrennen unterhalb des ersten Grabens 5 bzw. zweiten Grabens 6 jeweils die erste dotierte Schicht 2.

Der vierte Graben 15 wird mit einer zweiten Isolationsstruktur 17 zum Beispiel aus SiO₂ versehen, die in der Hohe bis in die erste Gateelektrode 9 hineinreicht. Darüber verbliebener Freiraum in dem vierten Graben 15 wird mit einer n⁺-dotierten Polysiliziumstruktur 18 aufgefüllt, die durch den vierten Graben 15 getrennte Teile der ersten Gateelektrode 9 elektrisch miteinander verbindet.

Der fünfte Graben 16 wird mit einer dritten Isolationsstruktur 19 aus zum Beispiel SiO₂ versehen, die den fünften Graben 16 vollständig ausfüllt. Die dritte Isolationsstruktur 19 im fünften Graben 16 durchtrennt die zweite Gateelektrode 10, die Diffusionsbarriereschicht 10a, die dotierte Polysiliziumstruktur 11 und die Metallsilizidschicht 12 in jeweils zwei voneinander isolierte Teile.

Im dritten Graben 13 wird oberhalb der ersten Isolationsstruktur 14 eine Verbindungsstruktur 20 aus zum Beispiel n-dotiertem Polysilizium erzeugt, die durch den dritten Graben 13 getrennte Teile der dritten dotierten Schicht 4 elektrisch miteinander verbindet. Vorzugsweise schließt die Verbindungsstruktur 20 eben mit der Oberfläche der dritten dotierten Schicht 4 ab.

Die zwischen dem dritten Graben 13 und dem vierten Graben 15 angeordneten Teile der ersten dotierten Schicht 2, zweiten dotierten Schicht 3, dritten dotierten Schicht 4, des ersten Gatedielektrikums 7 und der ersten Gateelektrode 9 bilden einen Auswahltransistor. Die zwischen dem dritten Graben 13 und dem fünften Graben 16 angeordneten Teile der ersten dotierten Schicht 2, zweiten dotierten Schicht 3, dritten dotierten Schicht 4, des zweiten Gatedielektrikums 8, und der zweiten Gateelektrode 10 bilden einen Speichertransistor. Der Auswahltransistor und der Speichertransistor weisen ein gemeinsames Source-Drain-Gebiet auf, das durch die entsprechenden Teile der dritten dotierten Schicht 4 sowie die Verbindungsstruktur 20 gebildet wird. Im übrigen werden der Auswahltransistor und der Speichertransistor durch die erste Isolationsstruktur 14 voneinander getrennt. Seitlich wird die Speicherzelle durch den vierten Graben 15 und den fünften Graben 16 begrenzt. An den vierten Graben 15 und den fünften Graben 16 schließen jeweils spiegelbildlich angeordnete, im übrigen analog aufgebaute Speicherzellen an.

Die dotierte Polysiliziumstruktur 11 und die zweite Gateelektrode 10 bilden eine pn⁺-Diode, durch die in diesem Ausführungsbeispiel eine Diodenstruktur realisiert wird, die zwischen das gemeinsame Source-Drain-Gebiet 4, 20 und die zweite Gateelektrode 10 geschaltet wird. Zur elektrischen Verbindung zwischen der pn⁺-Diode 10, 11 wird ein zum Beispiel n-dotierter Polysiliziumstreifen 21 erzeugt, der sowohl mit der Oberfläche der Metallsilizidschicht 12 als auch der dritten dotierten Schicht 4 zwischen dem dritten Graben 13 und dem fünften Graben 16 in Verbindung steht (siehe Figur 5).

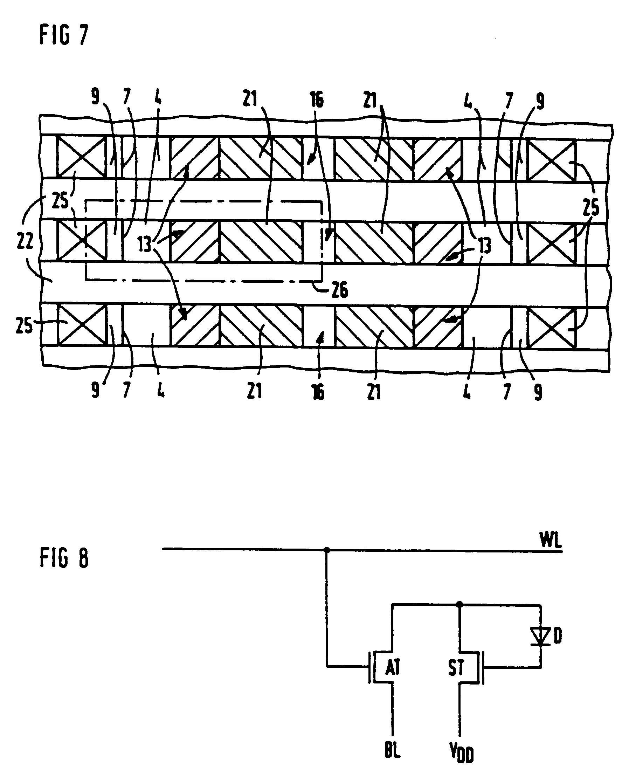

Der dritte Graben 13, der vierte Graben 15 sowie der fünfte Graben 16 verlaufen senkrecht zur Zeichenebene durch die gesamte Speicherzellenanordnung. Es werden quer zu dem dritten Graben 13, dem vierten Graben 15 und dem fünften Graben 16 verlaufende sechste Gräben erzeugt, die bis in die erste dotierte Schicht 2, zum Beispiel 100 nm unterhalb der Grenzfläche zur zweiten dotierten Schicht 3, hineinreichen und die mit vierten Isolationsstrukturen 22 (siehe Figur 7) aufgefüllt werden. Die sechsten Gräben verlaufen zum Beispiel im rechten Winkel zu den dritten Gräben 13 außerhalb der in Figur 5 und Figur 6 gezeigten Zeichenebene. Als gestrichelte Linie 23 ist in Figur 5 und Figur 6 die Tiefe der sechsten Gräben eingezeichnet. Die vierte Isolationsstruktur 22 isoliert entlang dem dritten Graben 13 benachbarte Auswahltransistoren bzw. Speichertransistoren. Zwischen dem dritten Graben 13 und dem vierten Graben 15 angeordnete Auswahltransistoren sind dabei durch den zwischen dem dritten Graben 13 und dem vierten Graben 15 und unterhalb des sechsten Grabens 23 angeordneten Teil der ersten dotierten Schicht elektrisch miteinander verbunden, der als Bitleitung 2a wirkt.

Zwischen dem dritten Graben 13 und dem fünften Graben 16 angeordnete Speichertransistoren sind über den zwischen dem dritten Graben 13 und dem fünften Graben 16 unterhalb des sechsten Grabens 23 angeordneten Teil der zweiten dotierten Schicht, der eine gemeinsame Versorgungsleitung 2b bildet, elektrisch miteinander verbunden.

Es wird ganzflächig eine Passivierungsschicht 24 aufgebracht, die zum Beispiel aus TEOS-SiO₂ hergestellt wird. In der Passivierungsschicht 24 werden Kontakt löcher zu den ersten Gateelektroden 9 geöffnet und durch Auffüllen mit einem geeigneten Metall, zum Beispiel Wolfram, mit einem Wortleitungskontakt 25 versehen. Dabei werden die ersten Gateelektroden 9 benachbarter Speicherzellen, die in demselben ersten Graben 5 angeordnet sind, mit einem gemeinsamen Wortleitungskontakt 25 versehen (siehe Figur 6). Die Wortleitungskontakte 25 werden zum Beispiel mit Hilfe einer Aluminiummetallisierung verdrahtet (nicht dargestellt).

Die vergrabenen Bitleitungen 2a und die Versorgungsspannungsleitungen 2b werden in Abständen, die wesentlich größer sind als das Rastermaß der Speicherzellen, mit Hilfe von Kontaktlöcher angeschlossen.

Da die Diodenstruktur in dieser Speicherzelle als pn-Übergang realisiert ist, der als obere Schicht jeweils im zweiten Graben 6 angeordnet ist, kann die Diodenstruktur in planaren Fertigungsschritten prozessiert werden, ohne daß dadurch die Gesamtfläche der Speicherzelle vergrößert würde.

Der Flächenbedarf der nach dem erfindungsgemäßen Herstellverfahren hergestellten Speicherzellen wird ferner dadurch gering gehalten, daß die Bitleitungen 2a und Versorgungsspannungsleitungen 2b in der Schichtstruktur vergraben sind. Dadurch werden weitere Verdrahtungsebenen für Bitleitungen oder Zuführung der Versorgungsspannung überflüssig.

Da entlang den sechsten Gräben angeordnete benachbarte Speicherzellen jeweils spiegelsymmetrisch aufgebaut sind, verlaufen die vergrabenen Bitleitungen 2a in Bitleitungspaaren. Daher können in diesem Konzept sowohl "open" als auch "folded" Bitleitungsarchitekturen verwirklicht werden.

Abweichend von dem oben beschriebenen Beispiel kann nach dem epitaktischen Aufbringen der ersten dotierten Schicht 2 eine SiO₂-Schicht in einer Dicke von etwa 500 bis 800 nm zur späteren Isolation der Transistoren aufgebracht werden. In diese SiO₂-Schicht werden Löcher für die aktiven Transistorgebiete geätzt, die mit selektiver Epitaxie jeweils mit der zweiten dotierten Schicht und der dritten dotierten Schicht aufgefüllt werden. Die strukturierte SiO₂-Schicht ersetzt in dieser Variante die Isolationsstrukturen 14, 17 und 19.

Figur 7 zeigt eine Aufsicht auf eine erfindungsgemäß hergestellte Speicherzellenanordnung. In diesem Beispiel verlaufen die mit der vierten Isolationsstruktur 22 jeweils gefüllten sechsten Gräben senkrecht zu den dritten Gräben 13. Die Gräben können sich jedoch auch unter einem beliebigen anderen Winkel schneiden. Zwischen benachbarten sechsten Gräben sind jeweils nebeneinander ein Wortleitungskontakt 25, der zwei benachbarten Speicherzellen angehört, die erste Gateelektrode 9, das erste Gatedielektrikum 7, ein Teil der dritten dotierten Siliziumschicht 4, der dritte Graben 13, der dotierte Polysiliziumstreifen 21 und der fünfte Graben 16, der wiederum benachbarten Speicherzellen gemeinsam angehört, angeordnet. Die Fläche einer einzelnen Speicherzelle 26 ist in Figur 7 als strichpunktierte Linie eingezeichnet.

Figur 8 zeigt ein Ersatzschaltbild für eine Speicherzelle. Die Speicherzelle umfaßt einen Auswahltransistor AT und einen Speichertransistor ST, die zwischen eine Bitleitung BL und eine Versorgungsspannungsleitung V_{DD} über ein gemeinsames Source-Drain-Gebiet in Reihe geschaltet sind. Zwischen das gemeinsame Source-Drain-Gebiet und die Gateelektrode des Speichertransistors ST ist eine Diodenstruktur D so geschaltet, daß ein niedriger Widerstandswert beim Aufladen und ein hoher Widerstandswert beim Entladen einer an der Gateelektrode des Speichertransistors wirksamen Kapazität auftritt. Die Gatelektrode des Auswahltransistors AT ist mit einer Wortleitung WL verbunden. Der Betrieb einer solchen Speicherzelle ist in WO 92/01287 beschrieben, auf die bezüglich des Betriebsverfahrens verwiesen wird.

## Patentansprüche

1. Verfahren zur Herstellung einer Anordnung mit selbstverstärkenden dynamischen MOS-Transistorspeicherzellen,
- bei dem ein Siliziumsubstrat (1) mit einer vertikalen Folge dotierter Gebiete versehen wird, die mindestens ein erstes dotiertes Gebiet (2), ein darauf angeordnetes zweites dotiertes Gebiet (3) und ein darauf angeordnetes drittes dotiertes Gebiet (4) für Source-, Kanal- und Drain-Gebiet von vertikalen MOS-Transistoren umfaßt,
- bei dem ein erster Graben (5) und ein zweiter Graben (6) geätzt werden, die bis in das erste Gebiet (2) hineinreichen und die das zweite Gebiet (3) und das dritte Gebiet (4) durchqueren,
- bei dem die Oberfläche des ersten Grabens (5) mit einem ersten Gatedielektrikum (7) und die Oberfläche des zweiten Grabens (6) mit einem zweiten Gatedielektrikum (8) versehen werden,
- bei dem im ersten Graben (5) eine erste Gateelektrode (9) und im zweiten Graben (6) eine zweite Gateelektrode (10) gebildet werden,
- bei dem zwischen dem ersten Graben (5) und dem zweiten Graben (6) ein dritter Graben (13) erzeugt wird, der das erste dotierte Gebiet (2), das zweite dotierte Gebiet (3) und das dritte dotierte Gebiet (4) durchtrennt,
- bei dem der dritte Graben (13) mindestens im Bereich des ersten dotierten Gebietes (2) und des zweiten dotierten Gebietes (3) mit einer ersten Isolationsstruktur (14) versehen wird,
- bei dem die durch den dritten Graben (13) getrennten Teile des dritten dotierten Gebietes (4) durch eine Verbindungsstruktur (20) elektrisch miteinander verbunden werden,
- bei dem eine Diodenstruktur erzeugt wird, deren einer Anschluß mit dem dritten dotierten Gebiet (4) und deren anderer Anschluß mit dem der zweiten Gateelektrode (10) elektrisch leitend verbunden ist.

2. Verfahren nach Anspruch 1,
- bei dem das Siliziumsubstrat (1) von einem ersten Leitfähigkeitstyp dotiert ist,
- bei dem zur Bildung des ersten dotierten Gebietes auf dem Siliziumsubstrat (1) eine von einem zweiten, dem ersten entgegengesetzten Leitfähigkeitstyp dotierte Siliziumschicht (2) epitaktisch aufgewachsen wird,
- bei dem zur Bildung des zweiten dotierten Gebietes (3) eine vom ersten Leitfähigkeitstyp dotierte Siliziumschicht (3) durch LPCVD-Epitaxie (Low Pressure Chemical Vapour Deposition-Epitaxie) oder durch Molekularstrahlepitaxie aufgebracht wird,
- bei dem zur Bildung des dritten dotierten Gebietes eine vom zweiten Leitfähigkeitstyp dotierte Siliziumschicht (4) durch LPCVD-Epitaxie oder durch Molekularstrahlepitaxie aufgebracht wird.

3. Verfahren nach Anspruch 1 oder 2,
bei dem die Diodenstruktur als Schottky-Diode realisiert wird.

4. Verfahren nach Anspruch 1 oder 2,
bei dem die Diodenstruktur als n⁺p-Diode (10, 11) realisiert wird.

5. Verfahren nach Anspruch 4,
- bei dem die zweite Gateelektrode (10) aus dotiertem Polysilizium gebildet wird,
- bei dem eine dotierte Polysiliziumstruktur (11) erzeugt wird, die mit der zweiten Gateelektrode (10) die Diodenstruktur darstellt,
- bei dem die dotierte Polysiliziumstruktur (11) mit dem dritten dotierten Gebiet elektrisch leitend verbunden wird.

6. Verfahren nach Anspruch 5,
- bei dem die zweite Gateelektrode (10) im zweiten Graben (6) in einer Höhe im wesentlichen entsprechend der Höhe des zweiten dotierten Gebietes (3) erzeugt wird,
- bei dem die dotierte Polysiliziumstruktur (11) im zweiten Graben (6) oberhalb der zweiten Gateelektrode (10) erzeugt wird,
- bei dem die Oberfläche der dotierten Polysiliziumstruktur (11) mit einer Metallsilizidschicht (12) versehen wird,
- bei dem ein dotierter Polysiliziumstreifen (21) erzeugt wird, der die Metallsilizidschicht (12) und das dritte dotierte Gebiet (4) jeweils mindestens teilweise überlappt.

7. Verfahren nach Anspruch 5 oder 6,
bei dem zwischen der zweiten Gateelektrode (10) und der dotierten Polysiliziumstruktur (11) eine Diffusionsbarriereschicht (10a) erzeugt wird.

8. Verfahren nach einem der Ansprüche 1 bis 7,
- bei dem die Dotierstoffkonzentration im ersten dotierten Gebiet (2) und im dritten dotierten Gebiet (4) im Bereich größer gleich 10¹⁹ eingestellt wird,
- bei dem die Dotierstoffkonzentration im zweiten dotierten Gebiet (3) im Bereich kleiner gleich 10¹⁸ eingestellt wird,
- bei dem das erste Gatedielektrikum (7) und das zweite Gatedielektrikum (8) bei 700 bis 800°C durch thermische Oxidation gebildet werden.

9. Verfahren nach einem der Ansprüche 1 bis 8,
bei dem die Verbindungsstruktur (20) über den dritten Graben (13) aus dotiertem Polysilizium von demselben Leitfähigkeitstyp wie das dritte dotierte Gebiet (4) gebildet wird.

10. Verfahren nach einem der Ansprüche 1 bis 9,
- bei dem im Siliziumsubstrat (1) eine Vielzahl matrixartig angeordneter Speicherzellen hergestellt werden,
- bei dem der erste Graben (5), der zweite Graben (6) und der dritte Graben (13) jeweils als parallele Streifen ausgebildet werden,
- bei dem innerhalb des ersten Grabens (5) ein vierter Graben (15) erzeugt wird, der das erste dotierte Gebiet (2) durchtrennt und in dem eine zweite Isolationsstruktur (17) gebildet wird, die mindestens die Teile des ersten dotierten Gebietes (2) beiderseits des vierten Grabens (15) voneinander isoliert,
- bei dem innerhalb des zweiten Grabens (6) ein fünfter Graben (16) erzeugt wird, der das erste dotierte Gebiet (4) durchtrennt und in dem eine dritte Isolationsstruktur (19) gebildet wird, die die Teile des ersten dotierten Gebietes (2), der zweiten Gateelektrode (10) sowie der Diodenstruktur (10, 11) beiderseits des fünften Grabens (16) voneinander isoliert,
- bei dem sechste Gräben erzeugt werden, die die ersten Gräben (5), die zweiten Gräben (6) und dritten Gräben (13) kreuzen, die bis in das erste dotierte Gebiet (2) hineinreichen, ohne das erste dotierte Gebiet (2) zu durchtrennen und die mit vierten Isolationsstrukturen (22) aufgefüllt werden,
- bei dem parallel zu den sechsten Gräben verlaufende Wortleitungen erzeugt werden, die über Wortleitungskontakte (25) mit den ersten Gateelektroden (9) elektrisch leitend verbunden werden,
- bei dem entlang einer Wortleitung benachbarte Speicherzellen spiegelsymmetrisch angeordnet werden,
- bei dem jeweils der zwischen dem ersten Graben (5) und dem dritten Graben (13) angeordnete Teil des ersten dotierten Gebietes (2) als Bitleitung (2a) und der zwischen dem dritten Graben (13) und dem zweiten Graben (6) angeordnete Teil des ersten dotierten Gebietes (2) als Versorgungsspannungsleitung (2b) verschaltet werden.

## Claims

1. Method of producing an arrangement containing self-amplifying dynamic MOS transistor memory cells,
- in which a silicon substrate (1) is provided with a vertical sequence of doped zones which comprises at least a first doped zone (2), a second doped zone (3) disposed thereon and a third doped zone (4) disposed thereon for source zone, channel zone and drain zone of vertical MOS transistors,
- in which a first trench (5) and a second trench (6) are etched which extend down into the first zone (2) and which traverse the second zone (3) and the third zone (4),
- in which the surface of the first trench (5) is provided with a first gate dielectric (7) and the surface of the second trench (6) is provided with a second gate dielectric (8),
- in which a first gate electrode (9) is formed in the first trench (5) and a second gate electrode (10) is formed in the second trench (6),
- in which a third trench (13) which cuts through the first doped zone (2), the second doped zone (3) and the third doped zone (4) is produced between the first trench (5) and the second trench (6),
- in which the third trench (13) is provided with a first isolation structure (14) at least in the region of the first doped zone (2) and of the second doped zone (3),
- in which those parts of the third doped zone (4) that are separated by the third trench (13) are electrically interconnected by an interconnect structure (20),
- in which a diode structure is produced whose one terminal is connected in an electrically conducting manner to the third doped zone (4) and whose other terminal is connected in an electrically conducting manner to that of the second gate electrode (10).

2. Method according to Claim 1,
- in which the silicon substrate (1) is doped with a first conductivity type,
- in which, to form the first doped zone, a silicon layer (2) doped with a second conductivity type opposite to the first is grown epitaxially on the silicon substrate (1),
- in which, to form the second doped zone (3) a silicon layer (3) doped with the first conductivity type is applied by LPCVD epitaxy (low-pressure chemical vapour deposition epitaxy) or by molecular-beam epitaxy,
- in which, to form the third doped zone, a silicon layer (4) doped with the second conductivity type is applied by LPCVD epitaxy or by molecular-beam epitaxy.

3. Method according to Claim 1 or 2, in which the diode structure is formed as a Schottky diode.

4. Method according to Claim 1 or 2, in which the diode structure is formed as an n⁺-p diode (10, 11).

5. Method according to Claim 4,
- in which the second gate electrode (10) is formed from doped polysilicon,
- in which a doped polysilicon structure (11) is produced which, with the second gate electrode (10), is the diode structure,
- in which the doped polysilicon structure (11) is connected in an electrically conducting manner to the third doped zone.

6. Method according to Claim 5,
- in which the second gate electrode (10) is produced in the second trench (6) in a height essentially corresponding to the level of the second doped zone (3),
- in which the doped polysilicon structure (11) is produced in the second trench (6) above the second gate electrode (10),
- in which the surface of the doped polysilicon structure (11) is provided with a metal silicide layer (12),
- in which a doped polysilicon strip (21) is produced in which the metal silicide layer (12) and the third doped zone (4) overlap at least partly in each case.

7. Method according to Claim 5 or 6,
- in which a diffusion-barrier layer (10a) is produced between the second gate electrode (10) and the doped polysilicon structure (11).

8. Method according to one of Claims 1 to 7,
- in which the dopant concentration in the first doped zone (2) and in the third doped zone (4) is adjusted in the range greater than or equal to 10¹⁹ cm⁻³,
- in which the dopant concentration in the second doped zone (3) is adjusted in the range less than or equal to 10¹⁸ cm⁻³,
- in which the first gate dielectric (7) and the second gate dielectric (8) are formed by thermal oxidation at 700 to 800°C.

9. Method according to one of Claims 1 to 8, in which the interconnect structure (20) is formed by means of the third trench (13) composed of doped polysilicon of the same conductivity type as the third doped zone (4).

10. Method according to one of Claims 1 to 9,
- in which a multiplicity of memory cells disposed in matrix fashion is produced in the silicon substrate (1),
- in which the first trench (5), the second trench (6) and the third trench (13) are each formed as parallel strips,
- in which there is produced, inside the first trench (5), a fourth trench (15) which cuts through the first doped zone (2) and in which a second isolation structure (17) is formed which isolates at least the parts of the first doped zone (2) on either side of the fourth trench (15) from one another,
- in which there is produced, inside the second trench (6), a fifth trench (16) which cuts through the first doped zone (4) and in which a third isolation structure (19) is formed which isolates the parts of the first doped zone (2), the second gate electrode (10) and the diode structure (10, 11) on either side of the fifth trench (16) from one another,
- in which sixth trenches are produced which cross the first trenches (5), the second trenches (6) and third trenches (13), which extend down into the first doped zone (2) without cutting through the first doped zone (2) and which are filled with fourth isolation structures (22),
- in which word lines are produced which extend parallel to the sixth trenches and which are connected in an electrically conducting manner to the first gate electrodes (9) via word-line contacts (25),
- in which adjacent memory cells are arranged in a mirror-symmetrical manner along a word line,
- in which, in each case, that part of the first doped zone (2) that is disposed between the first trench (5) and the third trench (13) is connected as bit line (2a) and that part of the first doped zone (2) that is disposed between the third trench (13) and the second trench (6) is connected as supply-voltage line (2b).

## Revendications

1. Procédé de fabrication d'un dispositif de cellules de mémoire dynamiques à auto-amplification à transistors MOS,
- dans lequel un substrat de silicium (1) est doté d'une suite verticale de zones dopées, qui comprend au moins une première zone dopée (2), une deuxième zone dopée (3) placée au-dessus de la première et une troisième zone dopée (4) placée au-dessus de la deuxième, pour les zones de source, de canal et de drain de transistors MOS verticaux,
- dans lequel une première tranchée (5) et une deuxième tranchée (6) sont gravées, qui s'avancent jusque dans la première zone (2) et qui traversent la deuxième zone (3) et la troisième zone (4),
- dans lequel la surface de la première tranchée (5) est pourvue d'un premier diélectrique de grille (7) et la surface de la deuxième tranchée (6) d'un deuxième diélectrique de grille (8),
- dans lequel une première électrode de grille (9) est réalisée dans la première tranchée (5) et une deuxième électrode de grille (10) dans la deuxième tranchée (6),
- dans lequel une troisième tranchée (13) est créée entre la première tranchée (5) et la deuxième tranchée (6), qui coupe la première zone dopée (2), la deuxième zone dopée (3) et la troisième zone dopée (4),
- dans lequel la troisième tranchée (13) est pourvue au moins au niveau de la première zone dopée (2) et de la deuxième zone dopée (3) d'une première structure isolante (14),
- dans lequel les parties de la troisième zone dopée (4), séparées par la troisième tranchée (13), sont reliées électriquement entre elles par une structure de liaison (20),
- dans lequel une structure de diode est créée, dont l'une des bornes est reliée électriquement à la troisième zone dopée (4) et l'autre à celle de la deuxième électrode de grille (10).

2. Procédé selon la revendication 1,
- dans lequel le substrat de silicium (1) est dopé d'un premier type de conductivité,
- dans lequel, pour former la première zone dopée (2), une couche de silicium (2) dopée d'un deuxième type de conductivité, opposé au premier, est déposée épitaxialement sur le substrat de silicium (1),
- dans lequel, pour former la deuxième zone dopée (3), une couche de silicium (3) dopée du premier type de conductivité est déposée par épitaxie LPCVD (Low Pressure Chemical Vapour Deposition) ou par épitaxie par faisceau moléculaire,
- dans lequel, pour former la troisième zone dopée (4), une couche de silicium (4) dopée du deuxième type de conductivité est déposée par épitaxie LPCVD ou par épitaxie par faisceau moléculaire.

3. Procédé selon la revendication 1 ou 2, dans lequel la structure de diode est réalisée sous forme de diode de type Schottky.

4. Procédé selon la revendication 1 ou 2, dans lequel la structure de diode est réalisée sous forme de diode n⁺p (10, 11).

5. Procédé selon la revendication 4,
- dans lequel la deuxième électrode de grille (10) est réalisée en polysilicium dopé,
- dans lequel une structure de polysilicium dopée (11) est créée, qui représente avec la deuxième électrode de grille (10) la structure de diode,
- dans lequel la structure de polysilicium dopée (11) est reliée électriquement à la troisième zone dopée.

6. Procédé selon la revendication 5,
- dans lequel la deuxième électrode de grille (10) dans la deuxième tranchée (6) est créée à une hauteur correspondant substantiellement à la hauteur de la deuxième zone dopée (3),
- dans lequel la structure de polysilicium dopée (11) dans la deuxième tranchée (6) est créée au-dessus de la deuxième électrode de grille (10),
- dans lequel la surface de la structure de polysilicium dopée (11) est pourvue d'une couche de siliciure métallique (12),
- dans lequel une bande de polysilicium dopée (21) est créée, qui recouvre à chaque fois au moins partiellement la couche de siliciure métallique (12) et la troisième zone dopée (4).

7. Procédé selon la revendication 5 ou 6, dans lequel une barrière de diffusion (10a) sous forme de couche est créée entre la deuxième électrode de grille (10) et la structure de polysilicium dopée (11).

8. Procédé selon l'une des revendications 1 à 7,
- dans lequel la concentration de dopant dans la première zone dopée (2) et dans la troisième zone dopée (4) est réglée à une valeur supérieure ou égale à 10¹⁹,
- dans lequel la concentration de dopant dans la deuxième zone dopée (3) est réglée à une valeur inférieure ou égale à 10¹⁸,
- dans lequel le premier diélectrique de grille (7) et le deuxième diélectrique de grille (8) sont formés par oxydation thermique à une température comprise entre 700 et 800°C.

9. Procédé selon l'une des revendications 1 à 8, dans lequel la structure de liaison (20) au-dessus de la troisième tranchée (13) est formée de polysilicium dopé du même type de conductivité que la troisième zone dopée (4).

10. Procédé selon l'une des revendications 1 à 9,
- dans lequel une multitude de cellules de mémoire disposées à la manière d'une matrice sont réalisées dans le substrat de silicium (1),
- dans lequel la première tranchée (5), la deuxième tranchée (6) et la troisième tranchée (13) sont réalisées à chaque fois sous forme de bandes parallèles,
- dans lequel une quatrième tranchée (15) est créée, à l'intérieur de la première tranchée (5), qui coupe la première zone dopée (2) et dans laquelle est formée une deuxième structure isolante (17) qui isole l'une de l'autre au moins les parties de la première zone dopée (2) de part et d'autre de la quatrième tranchée (15),
- dans lequel une cinquième tranchée (16) est créée, à l'intérieur de la deuxième tranchée (6), qui coupe la première zone dopée (4) et dans laquelle est formée une troisième structure isolante (19) qui isole l'une de l'autre les parties de la première zone dopée (2), de la deuxième électrode de grille (10) et de la structure de diode (10, 11) de part et d'autre de la cinquième tranchée (16),
- dans lequel des sixièmes tranchées sont créées, qui croisent les premières tranchées (5), les deuxièmes tranchées (6) et les troisièmes tranchées (13), qui s'avancent jusque dans la première zone dopée (2), sans couper la première zone dopée (2), et qui sont remplies de quatrièmes structures isolantes (22),
- dans lequel des lignes de mot s'étendant parallèlement aux sixièmes tranchées sont créées, qui sont reliées électriquement aux premières électrodes de grille (9) par l'intermédiaire de contacts de ligne de mot (25),
- dans lequel les cellules de mémoire contiguës le long d'une ligne de mot sont disposées symétriquement,
- dans lequel la partie de la première zone dopée (2), disposée entre la première tranchée (5) et la troisième tranchée (13), est montée sous forme de ligne de bit (2a), et la partie de la première zone dopée (2), disposée entre la troisième tranchée (13) et la deuxième tranchée (6), sous forme de ligne de tension d'alimentation (2b).
